# EUROPEAN PATENT APPLICATION

(11) **EP 2 738 823 A1**
(43) Date of publication of application: **04.06.2014**
(21) Application number: 12817607.0
(22) Date of filing: 16.03.2012
(51) Int. Cl.: H01L 31/0747, H01L 31/0224

(54) **SOLAR CELL**

(30) Priority: 28.07.2011 JP 2011165642
(71) Applicant: Sanyo Electric Co., Ltd., Moriguchi-shi, Osaka 570-8677 (JP)
(72) Inventor: ARIMOTO, Mamoru, Moriguchi-shi Osaka 570-8677 (JP)
(74) Representative: Glawe, Delfs, Moll
(86) International application number: PCT/JP2012/056888
(87) International publication number: WO 2013/014968

(57) **Abstract**

Provided is a solar cell with improved photoelectric conversion efficiency. A second busbar portion (15n) is arranged continuously across a first finger portion (14p) and a second finger portion (14n). The solar cell (1) is further provided with a first insulating layer (27). The first insulating layer (27) insulates the first finger portion (14p) and the second busbar portion (15n).

## Description

### FIELD OF THE INVENTION

The present invention relates to a back contact solar cell.

### BACKGROUND

Back contact solar cells are conventionally known (see, for example, Patent Document 1). It is not necessary to provide an electrode on the light-receiving surface of a back contact solar cell. As a result, the light-receiving efficiency of back contact solar cells can be improved. In this way, high photoelectric conversion efficiency can be realized.

### Prior Art Documents

### Patent Documents

Patent Document 1: Laid-Open Patent Publication No. 2010-80887

### SUMMARY

### Problem Solved by the Invention

There has been growing demand in recent years for solar cells with improved photoelectric conversion efficiency.

In view of this situation, it is an object of the present invention to provide a solar cell with improved photoelectric conversion efficiency.

### Means of Solving the Problem

A solar cell of the present application includes a photoelectric conversion unit, a first electrode, and a second electrode. The photoelectric conversion unit includes, on one main surface, a plurality of first surfaces of a first type of conductivity having a slender shape, and a plurality of second surfaces of a second type of conductivity having a slender shape. The plurality of first surfaces extend from one end to the other end of a first direction. The plurality of second surfaces extend from the other end to the one end. The first electrode has a plurality of finger portions and a first busbar portion. The plurality of first finger portions are arranged on the plurality of first surfaces so as to extend from the one end to the other end in the first direction. The first busbar portion is connected electrically to the plurality of first finger portions. The first busbar portion is arranged on the one end of the one main surface of the photoelectric conversion unit. The second electrode has a plurality of second finger portions and a second busbar portion. The plurality of second finger portions are arranged on the plurality of second surfaces so as to extend from the other end to the one end. The second busbar portion is connected electrically to the plurality of second finger portions. The second busbar portion is arranged on the other end of the one main surface of the photoelectric conversion unit. The second busbar portion is arranged continuously across the first finger portions and the second finger portions. The solar cell of the present invention also includes a first insulating layer. The first insulating layer insulates the first finger portions and the second busbar portion.

### Effect of the Invention

The present invention is able to provide a solar cell with improved photoelectric conversion efficiency.

### BRIEF DESCRIPTION OF THE DRAWINGS

FIG. 1 is a simplified plan view of the back surface of the solar cell in the first embodiment.
FIG. 2 is a simplified cross-sectional view from line II-II in FIG. 1.
FIG. 3 is a simplified cross-sectional view from line III-III in FIG. 1.
FIG. 4 is a simplified cross-sectional view from line IV-IV in FIG. 1.
FIG. 5 is a simplified cross-sectional view from line V-V in FIG. 1.
FIG. 6 is a simplified cross-sectional view from line VI-VI in FIG. 1.
FIG. 7 is a simplified cross-sectional view used to explain a manufacturing step for the solar cell in the first embodiment.
FIG. 8 is a simplified cross-sectional view used to explain a manufacturing step for the solar cell in the first embodiment.
FIG. 9 is a simplified cross-sectional view used to explain a manufacturing step for the solar cell in the first embodiment.
FIG. 10 is a simplified cross-sectional view used to explain a manufacturing step for the solar cell in the first embodiment.
FIG. 11 is a simplified cross-sectional view used to explain a manufacturing step for the solar cell in the first embodiment.
FIG. 12 is a simplified cross-sectional view of the solar cell in the second embodiment.

### DETAILED DESCRIPTION

The following is an explanation of examples of preferred embodiments of the present invention. The following embodiments are merely examples. The present invention is not limited by the following embodiments in any way.

Further, in each of the drawings referenced in the embodiments, members having substantially the same function are denoted by the same symbols. The drawings referenced in the embodiments are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

### 1 st Embodiment

### Configuration of Solar Cell 1

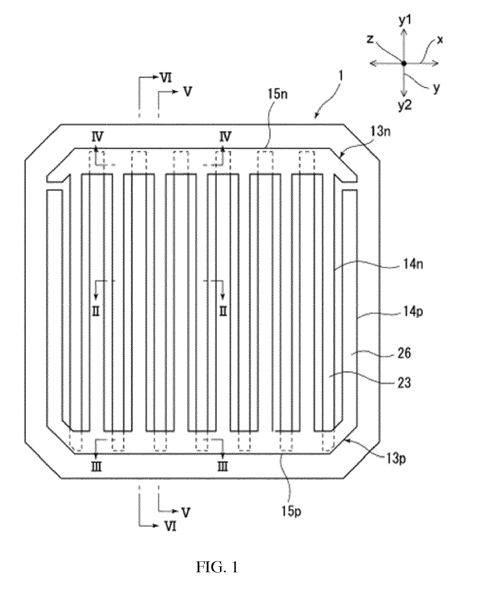

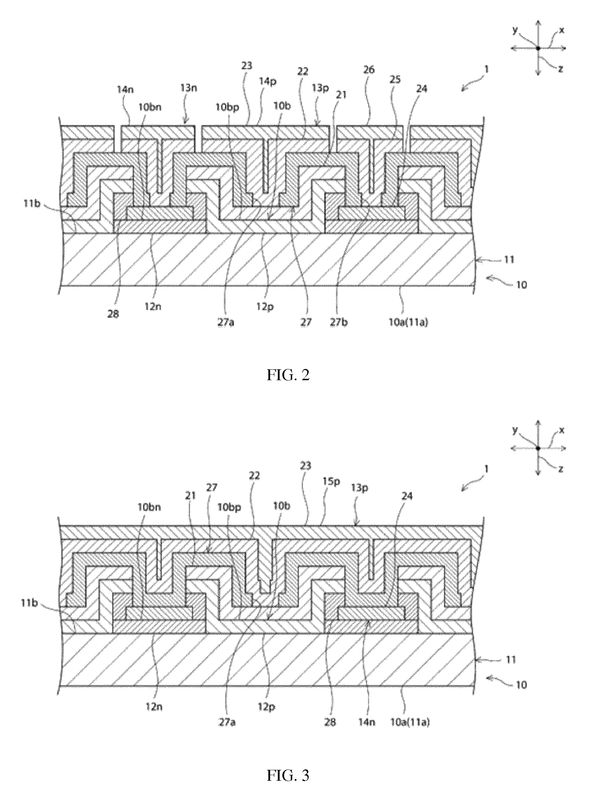

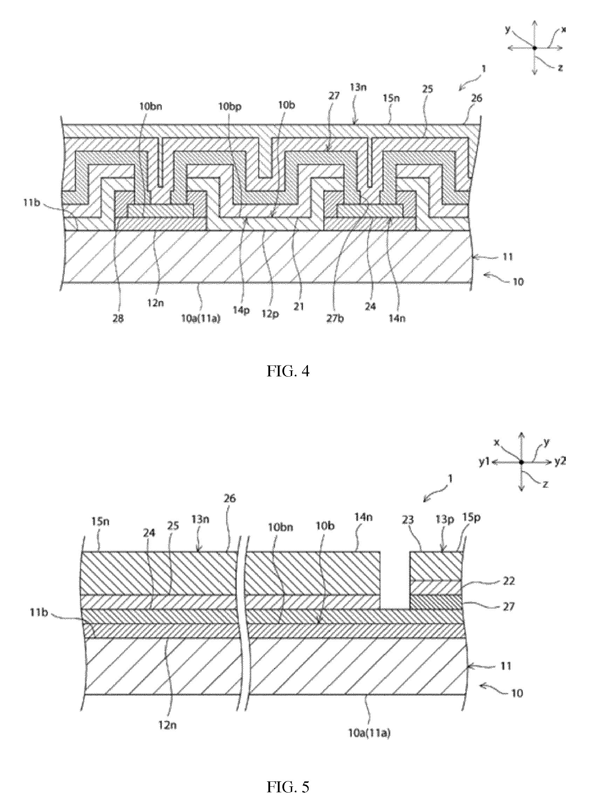

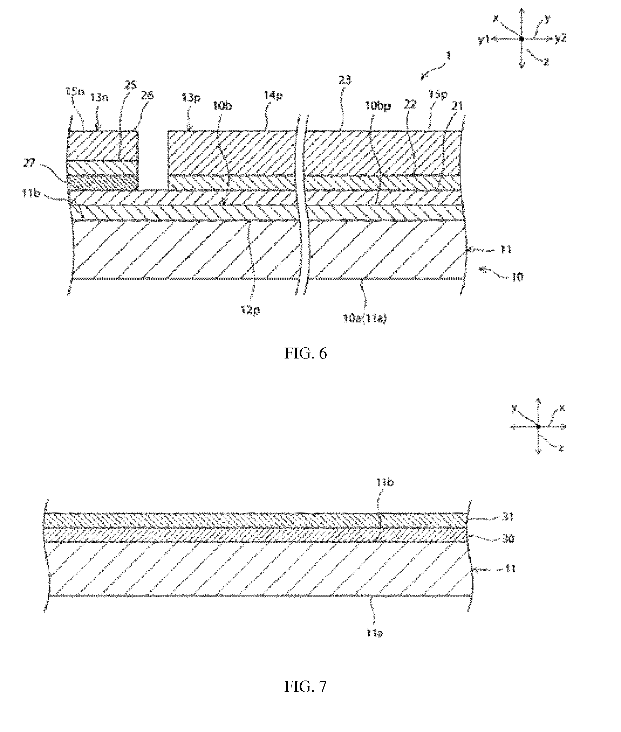

FIG. 1 is a simplified plan view of the back surface of the solar cell in the first embodiment. FIG. 2 is a simplified cross-sectional view from line II-II in FIG. 1. FIG. 3 is a simplified cross-sectional view from line III-III in FIG. 1. FIG. 4 is a simplified cross-sectional view from line IV-IV in FIG. 1. FIG. 5 is a simplified cross-sectional view from line V-V in FIG. 1. FIG. 6 is a simplified cross-sectional view from line VI-VI in FIG. 1.

The solar cell 1 includes a photoelectric conversion unit 10. The photoelectric conversion unit 10 is a portion that generates carriers (electrons and holes) when exposed to light. The photoelectric conversion unit 10 has a first main surface 10a and a second main surface 10b. The photoelectric conversion unit 10 primarily receives light over most of the first main surface 10a. Therefore, the first main surface 10a is referred to as the light-receiving surface, and the second main surface 10b is referred to as the back surface.

The photoelectric conversion unit 10 of the solar cell 1 includes a substrate 11 made of a semiconductor material having p-type or n-type conductivity, a p-type semiconductor layer 12p, and an n-type semiconductor layer 12n. The substrate 11 has a first main surface 11a and a second main surface 11b. The first main surface 11a is on the light-receiving side and the second main surface 11b is on the back side. In the present embodiment, the substrate 11 is an n-type substrate. Therefore, the minority carriers are holes and the majority carriers are electrons.

Both the p-type semiconductor layer 12p and the n-type semiconductor layer 12n are arranged on the second main surface 11b of the substrate 11. The p-type semiconductor layer 12p has a slender shape and extends from the y2-side end portion (the one end portion) in the y direction (the first direction) to the y1-side end portion (the other end portion). Meanwhile, the n-type semiconductor layer 12n has a slender shape and extends from the y1-side end portion in the y direction to the y2-side end portion. The p-type semiconductor layer 12p and the n-type semiconductor layer 12n are interdigitated in the x direction.

The p-type surface 10bp of the p-type semiconductor layer 12p and the n-type surface 10bn of the n-type semiconductor layer 12n are included in the second main surface 10b of the photoelectric conversion unit 10.

The p-type surface 10bp has a slender shape extending from the y2-side end portion to the y1-side end portion in the y direction. Meanwhile, the n-type surface 10bn has a slender shape extending from the y1-side end portion to the y2-side end portion in the y direction. The p-type surface 10bp and the n-type surface 10bn are interdigitated in the x direction (the second direction) which intersects the y direction.

The first main surface 11a of the substrate 11 may constitute the first main surface 10a of the photoelectric conversion unit 10. The first main surface 11a of the substrate 11 may also have a passivation layer, an anti-reflective layer, or a multilayer structure with a passivation layer and an anti-reflective layer. In this case, the passivation layer or anti-reflective layer constitutes the first main surface 10a of the photoelectric conversion unit 10.

Both end portions of the p-type semiconductor layer 12p in the x direction are positioned above both end portions of the n-type semiconductor layer 12n in the x direction. Both end portions of the p-type semiconductor layer 12p in the x direction and both end portions of the n-type semiconductor layer 12n in the x direction are separated by an insulating layer 28.

The substrate 11 can be composed of n-type crystalline silicon. The p-type semiconductor layer 12p can be composed of p-type amorphous silicon. The n-type semiconductor layer 12n can be composed of n-type amorphous silicon. Both the p-type semiconductor layer 12p and the n-type semiconductor layer 12n preferably contain hydrogen. An i-type semiconductor layer may be arranged between the n-type semiconductor layer 12n and the substrate 11 at a thickness that does not contribute substantially to the generation of electricity, for example, from several Å to 250 Å. Similarly, an i-type semiconductor layer may be arranged between the p-type semiconductor layer 12p and the substrate 11 at a thickness that does not contribute substantially to the generation of electricity, for example, from several Å to 250 Å. The i-type semiconductor layer may be composed of i-type amorphous silicon. The i-type semiconductor layer preferably contains hydrogen. The insulating layer 28 can be composed of silicon nitride, silicon oxide or silicon oxynitride. The insulating layer 28 preferably contains hydrogen.

The p-side electrode 13p is connected electrically to the p-type surface 10bp. The p-side electrode 13p is the electrode that collects holes or the minority carriers. As shown in FIG. 1, the p-side electrode 13p functionally has a plurality of p-side finger portions 14p and a p-side busbar portion 15p. Each of the p-side finger portions 14p is arranged on the p-side surface 10bp so as to extend from the y2-side end portion to the y1-side end portion in the y direction. The p-side finger portions 14p are interdigitated at intervals in the x direction.

The p-side finger portions 14p are connected electrically to the p-side busbar portion 15p. The p-side busbar portion 15p is arranged on the second main surface 10b of the photoelectric conversion unit 10 so as to extend along the y2-side end portion in the y direction. More specifically, in the present embodiment, the p-side busbar portion 15p is arranged continuously over the p-side finger portions 14p and the n-side finger portions 14n described below on the y2-side end portion of the second main surface 10b of the photoelectric conversion unit 10 in the y direction. The p-side busbar portion 15p is arranged on one end portion of the p-side finger portions 14p in the y direction.

The n-side electrode 13n is connected electrically to the n-type surface 10bn. The n-side electrode 13n is the electrode that collects electrons or the majority carriers. As shown in FIG. 1, the n-side electrode 13n functionally has a plurality of n-side finger portions 14n and a n-side busbar portion 15n. Each of the n-side finger portions 14n is arranged on the n-type surface 10bn so as to extend from the y1-side end portion to the y2-side end portion in the y direction. The n-side finger portions 14n interdigitated at intervals in the x direction. The n-side finger portions 14n and the p-side finger portions 14p are interdigitated in the x direction.

The n-side finger portions 14n are connected electrically to the n-side busbar portion 15n. The n-side busbar portion 15n is arranged on the second main surface 10b of the photoelectric conversion unit 10 so as to extend along the y1-side end portion in the y direction. The n-side busbar portion 15n is arranged continuously over the p-side finger portions 14p and the n-side finger portions 14n on the y1-side end portion of the second main surface 10b of the photoelectric conversion unit 10 in the y direction. The n-side busbar portion 15n is arranged over the other end portion of the n-side finger portions 14n in the y direction.

The p-side electrode 13p configurationally includes a first p-side TCO layer 21, a second p-side TCO layer 22, and a p-side metal layer 23. The first p-side TCO layer 21 is arranged on the p-type surface 10bp. The second p-side TCO layer 22 is arranged on the first p-side TCO layer 21. The p-side metal layer 23 is arranged on the second p-side TCO layer 22.

More specifically, as shown in FIG. 2 and FIG. 3, the portion of the p-side electrode 13p excluding the portion located underneath the n-side busbar portion 15n in the p-side finger portions 14p include a first p-side TCO layer 21, a second p-side TCO layer 22, and a p-side metal layer 23. The portion located underneath the n-side busbar portion 15n in the p-side finger portions 14p is composed of the first p-side TCO layer 21, but does not have the second p-side TCO layer 22 and the p-side metal layer 23.

Also, as shown in FIG. 3, the p-side busbar portion 15p includes a first p-side TCO layer 21, a second p-side TCO layer 22, and a p-side metal layer 23. However, in the p-side busbar portion 15p, the first p-side TCO layer 21 is provided on the p-type surface 10bp of the p-type semiconductor layer 12p, but not on a portion of the n-type surface 10bn of the n-type semiconductor layer 12n. Meanwhile, the second p-side TCO layer 22 and the p-side metal layer 23 are provided on both the p-type surface 10bp of the p-type semiconductor layer 12p and the n-type surface 10bn of the n-type semiconductor layer 12n.

The n-side electrode 13n configurationally includes a first n-side TCO layer 24, a second n-side TCO layer 25, and an n-side metal layer 26. The first n-side TCO layer 24 is arranged on the n-type surface 10bn. The second n-side TCO layer 25 is arranged on the first n-side TCO layer 24. The n-side metal layer 26 is arranged on the second n-side TCO layer 25.

More specifically, as shown in FIG. 2 and FIG. 4, the portion of the n-side electrode 13n excluding the portion located underneath the p-side busbar portion 15p in the n-side finger portions 14n include a first n-side TCO layer 24, a second n-side TCO layer 25, and a n-side metal layer 26. As shown in FIG. 3, the portion located underneath the p-side busbar portion 15p in the n-side finger portions 14n is composed of the first n-side TCO layer 24, but does not have the second n-side TCO layer 25 and the n-side metal layer 26.

Also, as shown in FIG. 4, the n-side busbar portion 15n includes a first n-side TCO layer 24, a second n-side TCO layer 25, and an n-side metal layer 26. However, in the n-side busbar portion 15n, the first n-side TCO layer 24 is provided on the n-type surface 10bn of the n-type semiconductor layer 12n, but not on a portion of the p-type surface 10bp of the p-type semiconductor layer 12p. Meanwhile, the second n-side TCO layer 25 and the n-side metal layer 26 are provided on both the n-type surface 10bn of the n-type semiconductor layer 12n and the p-type surface 10bp of the p-type semiconductor layer 12p.

The first p-side TCO layer 21, the second p-side TCO layer 22, the first n-side TCO layer 24 and the second n-side TCO layer 25 are all composed of a transparent conductive oxide such as indium oxide or zinc oxide containing a dopant.

The p-side metal layer 23 and the n-side metal layer 26 can be composed of a metal such as Cu, Ag, Au or Al, or an alloy including one or more of these metals. The p-side metal layer 23 and the n-side metal layer 26 can also be plated films.

In the solar cell 1, an insulating layer 27 is provided to insulate the p-side finger portions 14p and the n-side busbar portion 15n. The insulating layer 27 also insulates the n-side finger portions 14n and the p-side busbar portion 15p. In other words, in the present embodiment, the first insulating layer insulating the p-side finger portion 14p and the n-side busbar portion 15n, and the second insulating layer insulating the n-side finger portions 14n and the p-side busbar portion 15p are integrally provided. The insulating layer 27 can be composed of silicon nitride or silicon oxide. Through-holes 27a, 27b are provided in the insulating layer 27.

Under the n-side busbar portion 15n, the region in which the insulating layer 27 is arranged on the p-side finger portion 14p and the region in which the p-side finger portion 14p and the insulating layer 27 are not provided and the first n-side TCO layer 24 is exposed from the insulating layer 27 via through-hole 27b are provided alternatingly in the x direction. The second n-side TCO layer 25 and the first n-side TCO layer 24 are connected via the through-hole 27b.

Under the p-side busbar portion 15p, the region in which the insulating layer 27 is arranged on the n-side finger portion 14n and the region in which the n-side finger portion 14n and the insulating layer 27 are not provided and the first p-side TCO layer 21 is exposed from the insulating layer 27 via through-hole 27a are provided alternatingly in the x direction. The second p-side TCO layer 22 is connected to the first p-side TCO layer 21 via the through-hole 27a.

### Manufacturing Method For Solar Cell 1

FIG. 7 through FIG. 11 are simplified cross-sectional diagrams used to explain the manufacturing steps for the solar cell 1. The simplified cross-sectional diagrams shown in FIG. 7 through FIG. 11 show the portion corresponding to line II-II in FIG. 1.

The following is an explanation of an example of a manufacturing method for the solar cell 1. First, a semiconductor layer 30 constituting the n-type semiconductor layer 12n, and the TCO layer 31 constituting the first n-type TCO layer 24 are formed in successive order on the second main surface 11b of a substrate 11 made of a semiconductor material (FIG. 7). The semiconductor layer 30 and the TCO layer 31 can be formed using a chemical vapor deposition method such as the plasma CVD method or another thin-film forming method such as the sputtering method.

Next, the first n-side TCO layer 24 is formed by partially removing the TCO layer 31. The TCO layer 31 can be partially removed by performing etching using a resist mask. A patterned first n-side TCO layer 24 may be formed directly without forming a TCO layer 31.

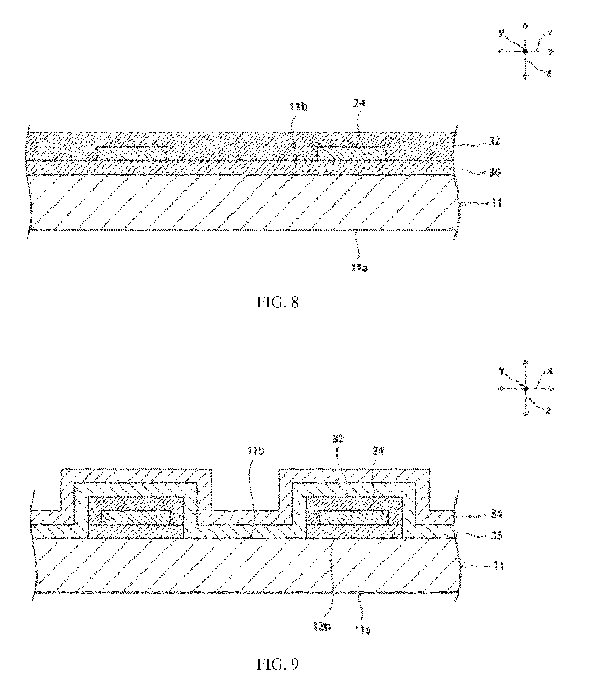

Next, an insulating layer 32 is formed to cover the semiconductor layer 30 and the first n-side TCO layer 24 (FIG. 8). The insulating layer 32 can be formed using a thin-film forming method such as the sputtering method or the CVD method.

Next, the insulating layer 32 and the semiconductor layer 30 are partially removed to form the n-type semiconductor layer 12n from the semiconductor layer 30 and partially expose the second main surface 11b of the substrate 11. The insulating layer 32 and the semiconductor layer 30 can be partially removed by performing etching using a resist mask.

Next, a semiconductor layer 33 constituting the p-type semiconductor layer 12p, and the TCO layer 34 constituting the first p-side TCO layer 21 are formed in successive order to cover the exposed portion of the second main surface 11b of the substrate 11 on the insulating layer 32 (FIG. 9). The semiconductor layer 33 and the TCO layer 34 can be formed using a chemical vapor deposition method such as the plasma CVD method or another thin-film forming method such as the sputtering method.

Next, the semiconductor layer 33, the TCO layer 34 and the insulating layer 32 are partially removed. In this way, insulating layer 28 is formed from insulating layer 32. A slender p-type semiconductor layer 12p is formed from the semiconductor layer 33. A first p-side TCO layer 21 is formed from the TCO layer 34. A portion of the first n-side TCO layer 24 is also exposed.

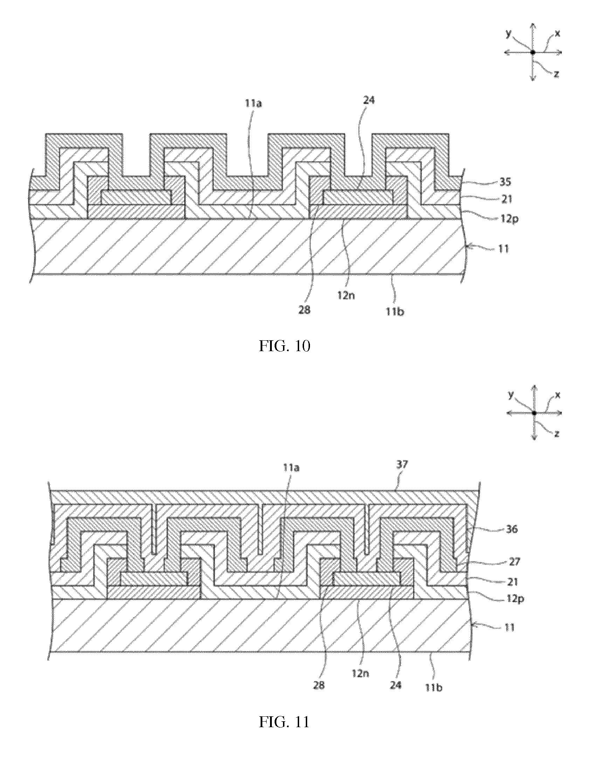

Next, an insulating layer 35 is formed to constitute insulating layer 27 and cover the exposed portion of the first n-side TCO layer 24 and the first p-side TCO layer 21 (FIG. 10). The insulating layer 35 can be formed using a thin-film forming method such as the sputtering method or the CVD method.

Next, insulating layer 27 is formed and a portion of the first p-side TCO layer 21 and a portion of the first n-side TCO layer 24 are exposed by partially removing the insulating layer 35. The insulating layer 35 can be partially removed by etching using a resist mask.

Next, the TCO layer 36 constituting the second p-side TCO layer 22 and the second n-side TCO layer 25 is formed, and the metal layer 37 constituting the p-side metal layer 23 and the n-side metal layer 26 is formed (FIG. 11). The TCO layer 36 can be formed using a thin-film forming method such as the sputtering method or the CVD method. The p-side metal layer 23 and the n-side metal layer 26 can be formed using a thin-film forming method such as the sputtering method or the CVD method, a plating method, or the application of a conductive paste.

At this time, the first p-side TCO layer 21 is not exposed in the region in which the n-side busbar portion 15n has been formed. The insulating layer 35 is partially removed to expose a portion of the first n-side TCO layer 24. The first n-side TCO layer 24 is also not exposed in the region in which the p-side busbar portion 15p has been formed. The insulating layer 35 is partially removed to expose a portion of the first p-side TCO layer 21.

Finally, the second p-side TCO layer 22 and the second n-side TCO layer 25 are formed from the TCO layer 36 and the p-side metal layer 23 and the n-side metal layer 26 are formed from the metal layer 37 by partially removing the TCO layer 36 and the metal layer 37 (FIG. 2).

At this time, the TCO layer 36 and the metal layer 37 have not been removed in the region in which the n-side busbar portion 15n and the p-side busbar portion 15p have been formed. However, the TCO layer 36 and the metal layer 37 have been removed between the region in which the n-side busbar portion 15n has been formed and the region in which the p-side finger portions 14p have been formed. Similarly, the TCO layer 36 and the metal layer 37 have not been removed in the region in which the p-side busbar portion 15p and the n-side finger portions 14n have been formed. The TCO layer 36 and the metal layer 37 can be partially removed by etching using a resist mask.

The solar cell 1 can be completed using these steps.

In a solar cell of the prior art, the n-type surface is positioned in the region beneath the n-side busbar portion for collecting the majority carrier. The p-type surface and the p-side electrode are not positioned in this region. The holes or minority carrier generated in this region have to migrate a long distance to be collected by the p-side finger portions. As a result, they are more likely to be lost by recombination before being collected by the p-side finger portions. Similarly, the electrons generated in the region of the substrate beneath the p-side busbar portions have to migrate a long distance to be collected by the n-side finger portions. As a result, they are more likely to be lost by recombination before being collected by the n-side finger portions.

However, in the present embodiment, the n-side busbar portion 15n is arranged continuously over the p-side finger portions 14p and the n-side finger portions 14n above the p-side surface 10bp. As a result, the holes generated in the region of the substrate 11 beneath the n-side busbar portion 15n only have to migrate a short distance to be collected by the p-side finger portions 14p. This can suppress via recombination the loss of holes generated in this region.

Also, the p-side busbar portion 15p is arranged continuously over the n-side finger portions 14n and the p-side finger portions 14p above the n-type surface 10bn. As a result, the electrons generated in the region of the substrate 11 beneath the p-side busbar portion 15p only have to migrate a short distance to be collected by the n-side finger portions 14n. This can suppress via recombination the loss of electrons generated in this region.

Therefore, improved photoelectric conversion efficiency can be realized in the solar cell 1.

Improved photoelectric conversion efficiency can be obtained even when the p-side finger portions 14p or n-side finger portions 14n are arranged between the either the n-side busbar portion 15n or p-side busbar portion 15p and the photoelectric conversion unit 10. Because suppressing loss of the minority carrier via recombination contributes significantly to improved photoelectric conversion efficiency, it is preferable that at least the p-side finger portions 14p be arranged between the n-side busbar portion 15n and the photoelectric conversion unit 10.

In the solar cell 1 of the present embodiment, a p-side busbar portion 15p is provided that is connected electrically to the p-side finger portions 14p. The metal layer 23 can be readily formed to the desired thickness using plating. Similarly, an n-side busbar portion 15n is provided in the solar cell 1 that is connected electrically to the n-side finger portions 14n. The metal layer 26 can be readily formed to the desired thickness using plating.

In the solar cell 1, both the p-side electrode 13p and the n-side electrode 13n have, in addition to the first p-side TCO layer 21, the second p-side TCO layer 22, the first n-side TCO layer 24 and the second n-side TCO layer 25, a p-side metal layer 23 and n-side metal layer 26 with a lower electrical resistance than these TCO layers. As a result, both the p-side electrode 13p and the n-side electrode 13n have low electrical resistance. Therefore, even better photoelectric conversion efficiency can be obtained.

The following is an explanation of another example of a preferred embodiment of the present invention. In the following explanation, members with functions substantially identical to those in the first embodiment are denoted by the same reference numbers and further explanation of these members has been omitted.

### 2nd Embodiment

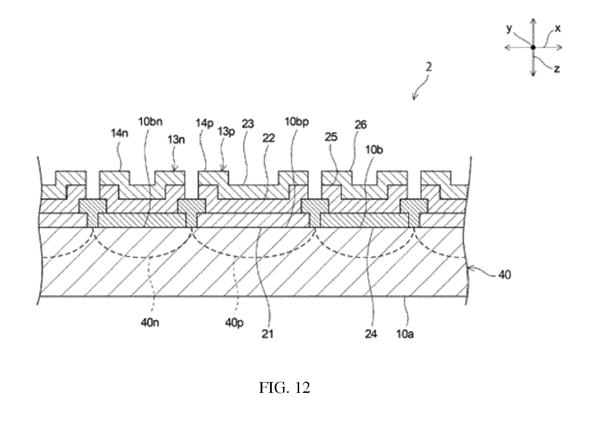

FIG. 12 is a simplified cross-sectional view of the solar cell in the second embodiment.

In the solar cell 1 of the first embodiment, the photoelectric conversion unit 10 has a substrate 11 made of a semiconductor material, a p-type semiconductor layer 12p constituting the p-type surface 10bp, and an n-type semiconductor layer 12n constituting the n-type surface 10bn. However, in the present invention the photoelectric conversion unit is not restricted to having a p-type surface and an n-type surface on the same main surface.

For example, as shown in FIG. 12, the photoelectric conversion unit 10 of the solar cell 2 in the second embodiment may have a substrate 40 made of a semiconductor material, an n-type dopant diffusion region 40n constituting the n-type surface 10bn, and a p-type dopant diffusion region 40p constituting the p-type surface 10bp.

The present invention includes many embodiments not described herein. For example, the finger portions positioned between the busbar portion and the photoelectric conversion unit may be composed of a stacked body consisting of a TCO layer and a metal layer, or may be composed simply of a metal layer.

Finger portions do not have to be provided between the photoelectric conversion unit and either the p-side busbar portion or the n-side busbar portion.

Also, the substrate made of a semiconductor material may be a p-type substrate.

The present invention includes many other embodiments not described herein. Therefore, the technical scope of the present invention is defined solely by the items of the invention specified in the claims pertinent to the above explanation.

### Key to the Drawings

1: solar cell
10: photoelectric conversion unit
10a: 1st main surface (light-receiving surface)
10b: 2nd main surface (back surface)
10bn: n-type surface
10bp: p-type surface
11: substrate
12n: n-type semiconductor layer
12p: p-type semiconductor layer
13n: n-side electrode
13p: p-side electrode
14n: n-side finger portion
14p: p-side finger portion
15n: n-side busbar portion
15p: p-side busbar portion
21: 1 st p-side TCO layer
22: 2nd p-side TCO layer
24: 1st n-side TCO layer
25: 2nd n-side TCO layer
23: p-side metal layer
26: n-side metal layer
27, 28: insulating layer
40n: n-type dopant diffusion region
40p: p-type dopant diffusion region

## Claims

1. A solar cell comprising:
a photoelectric conversion unit including on one main surface a plurality of first surfaces of a first type of conductivity having a slender shape and extending from one end to the other end in a first direction, and a plurality of second surfaces of a second type of conductivity having a slender shape and extending from the other end to the one end;
a first electrode having a plurality of first finger portions arranged on each of the plurality of first surfaces so as to extend from the one end to the other end in the first direction, and a first busbar portion arranged on the one side of the one main surface of the photoelectric conversion unit and connected electrically to the plurality of first finger portions; and
a second electrode having a plurality of second finger portions arranged on each of the plurality of second surfaces so as to extend from the other end to the one end, and a second busbar portion arranged on the other side of the one main surface of the photoelectric conversion unit and connected electrically to the plurality of second finger portions;
the second busbar portion being arranged continuously across the first finger portion and the second finger portion; and
the solar cell further comprising a first insulating layer insulating the first finger portions and the second busbar portion.

2. The solar cell according to claim 1, wherein the first electrode is an electrode for collecting the minority carrier, and the second electrode is an electrode for collecting the majority carrier.

3. The solar cell according to claim 1 or claim 2, wherein the first busbar portion is arranged continuously across the first finger portions and the second finger portions, and
the solar cell has a second insulating layer insulating the first busbar portion and the second finger portions.

4. The solar cell according to claim 3, wherein the first insulating layer and the second insulating layer are integrally provided.

5. The solar cell according to any one of claims 1 through 4, wherein each of the first electrode and the second electrode has a first transparent conductive oxide layer, a second transparent conductive oxide layer arranged on the first transparent conductive oxide layer, and a metal layer arranged on the second transparent conductive oxide layer; and
the second transparent conductive oxide layer and the metal layer in the second busbar portion are arranged continuously across the first finger portions and the second finger portions.

6. The solar cell according to any one of claims 1 through 5, wherein the photoelectric conversion unit comprises:
a substrate made of a semiconductor material having the first or second type of conductivity;
a first semiconductor layer composing the first surface arranged on the one main surface of the substrate; and
a second semiconductor layer composing the second surface arranged on the one main surface of the substrate; and

7. The solar cell according to any one of claims 1 through 5, wherein the photoelectric conversion unit comprises:
a substrate made of a semiconductor material having the first or second type of conductivity;
a first dopant diffusion region composing the first surface arranged on the substrate; and
a second dopant diffusion region composing the second surface arranged on the substrate.
